# EUROPEAN PATENT APPLICATION

(11) **EP 2 302 992 A1**
(43) Date of publication of application: **30.03.2011**
(21) Application number: 10010898.4
(22) Date of filing: 27.09.2010
(51) Int. Cl.: H05K 13/04, H05K 13/08

(54) **Board assembling apparatus and method of controlling the board assembling apparatus**

(30) Priority: 29.09.2009 JP 2009225657
(71) Applicant: Hitachi High-Tech Instruments Company, Ltd., Kumagaya-shi Saitama 360-0238 (JP)
(72) Inventor: Imoto, Takuya, Ora-gun, Gunma (JP); Iida, Shigeru, Ota-shi, Gunma (JP)
(74) Representative: Glawe, Delfs, Moll

(57) **Abstract**

The invention increases the production efficiency of printed circuit boards by enabling an apparatus that already completes production in a board assembling line to perform a setup change operation of each of work components after the completion. All electronic components are mounted on a board (P). A production number counter (30 increases the count number by "1" each time when all electronic components are mounted on a printed board (P), and a CPU (21) judges whether or not the number of produced boards reaches a set production number. When the CPU (21) judges that the number of produced boards reaches the set production number, all the printed boards (P) in this electronic component mounting apparatus (1) are discharged to the next process, and a printed board (P) is inhibited from being brought to this electronic component mounting apparatus (1). Then the CPU (21) judges whether or not the next production type registration is completed, and when the CPU (21) judges that the next production type registration is completed, the CPU (21) changes production type data. Then a necessary setup change is made based on a formed setup change list, corresponding to the next type of printed boards (P) to be produced.

## Description

### BACKGROUND OF THE INVENTION

### Field of the Invention:

The invention relates to a board assembling apparatus forming a board assembling line for a work of mounting electronic components on a printed board, and a method of controlling in the board assembling apparatus.

An electronic component mounting apparatus as this type of board assembling apparatus is disclosed in Japanese Patent Application No. 2007-96176, for example. In general, when an operation of producing a predetermined number of printed circuit boards is completed, a manager changes the board type manually corresponding to the next printed circuit boards to be produced. At this time, in a case where a plurality of electronic component mounting apparatuses as board assembling apparatuses are connected, during the time from the discharge of a last printed board by the top apparatus until the completion of production by the last apparatus, the apparatus that already completes production needs wait and do not work for production.

However, when the apparatus that already completes production in the board assembling line wait until the last apparatus completes production, the production efficiency in the board assembling line decreases accordingly. It is an object of this invention to provide an improved board assembling apparatus and method of controlling thereof.

### SUMMARY OF THE INVENTION

The solution according to the invention resides in the features of the independent claims and preferably in those of the dependent claims.

The invention increases the production efficiency of printed circuit boards by enabling an apparatus that already completes production in a board assembling line to perform a setup change operation to each of work components during the time until a last apparatus completes production or the time when a downstream board assembling apparatus is producing printed circuit boards.

The invention provides a method of controlling a board assembling apparatus (1) forming a board assembling line and including a plurality of work components (2, 5) necessary for a work of mounting electronic components on a board, the method including: performing a work of mounting electronic components on a first board (P) based on a first production type data stored in a memory (23); judging whether or not a second production type data necessary for a work of mounting electronic components on a second board (P) is stored in the memory (23) when the work of mounting the electronic components on the first board (P) is completed; and performing a necessary setup change operation of the work components (2, 5) based on the first and second production type data so as to perform the work of mounting the electronic components on the second board (P) when it is judged that the second production type data is stored in the memory (23).

The invention also provides a board assembling apparatus forming a board assembling line and including a plurality of work components necessary for a work of mounting electronic components (2, 5) on a board, the board assembling apparatus including: a memory (23); a first judging means (21) a judging whether or not a second production type data necessary for a work of mounting electronic components on a second board (P) is stored in the memory (23) when a work of mounting electronic components on a first board (P) based on first production type data stored in the memory (23) is completed; and control means (21) performing a necessary setup change operation of the work components (2, 5) based on the first and second production type data so as to perform the work of mounting the electronic components on the second board (P) when it is judged that the second production type data is stored in the memory (23).

### BRIEF DESCRIPTION OF THE DRAWINGS

Fig. 1 is a plan view of an electronic component mounting apparatus.
Fig. 2 is a control block diagram.
Fig. 3 shows mounting data.
Fig. 4 shows component disposition data.
Fig. 5 shows component library data.
Fig. 6 is a flow chart for next production type registration.
Fig. 7 shows production type data for printed boards to be produced soon or printed boards under production.
Fig. 8 shows next production type data.
Fig. 9 is a flow chart for setup during production.
Fig. 10 shows a production order list edit screen.
Fig. 11 shows stored data about the set types and numbers of printed boards to be produced.

### DETAILED DESCRIPTION OF THE INVENTION

In a board assembling line for an operation of mounting electronic components on a printed board, each of board assembling apparatuses forming this board assembling line includes a screen printing apparatus that coats solder paste on a printed board, an adhesive coating apparatus that coats an adhesive on a printed board, an electronic component mounting apparatus that mounts an electronic component picked up from a component feeding unit by a suction nozzle mounted on a mounting head and mounts the electronic component on a printed board, and so on. For simplicity, however, the following description will use only one electronic component mounting apparatus 1 as one of the board assembling apparatuses of which the controls of the board productions are manageable in the board assembling line. However, the invention is not limited to this electronic component mounting apparatus 1. The invention is also applicable to other screen printing apparatus and other adhesive coating apparatus, and further applicable to all the board assembling apparatuses that form a board assembling line.

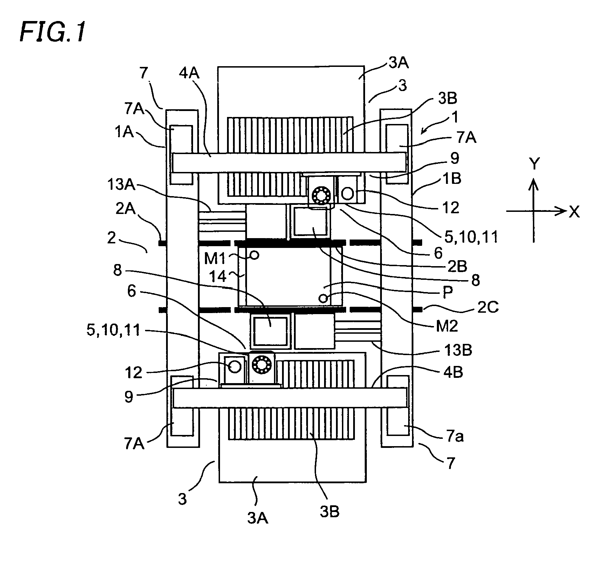

Referring to Fig. 1, an electronic component mounting apparatus 1 that forms a board assembling line and mounts electronic components on a printed board is provided with a carrying device 2 carrying a printed board P, component feeding devices 3 disposed on the front and rear sides between which the carrying device 2 is disposed and supplying electronic components, a pair of beams 4A, 4B movable in one direction (Y direction) by drive sources, and mounting heads 6 each having a plurality of suction nozzles 5 (e.g. 12 nozzles) as holding means detachably, that are movable along the beams 4A, 4B and rotatable by drive sources respectively.

The carrying device 2 is disposed in the middle portion of the electronic component mounting apparatus 1, and has a board supply portion 2A receiving a printed board P from an upstream apparatus, a board positioning portion 2B positioning and fixing a printed board P supplied from the board supply portion 2A so as to mount electronic components held by suction by the suction nozzles 5 of the mounting heads 6 thereon, and a board discharging portion 2C receiving a printed board P on which electronic components are mounted at the board positioning portion 2B and discharging the printed board P to a downstream apparatus. These board supply portion 2A, board positioning portion 2B and board discharging portion 2C are made of a pair of conveyers of which the space is adjustable corresponding to the width of a printed board P (the width in the direction perpendicular to the carrying direction).

The component feeding device 3 includes a feeder base 3A detachably mounted on the body of the electronic component mounting apparatus 1 and a group of component feeding units 3B detachably arrayed on this feeder base 3A and supplying various electronic components to those component pickup portions (component suction positions) one by one. A storage tape is provided to the component feeding unit 3B, including a carrier tape having concave storage portions where multiple electronic components are stored at given intervals and a cover tape covering the carrier tape. By intermittently forwarding the storage tape to peel the cover tape from the carrier tape, electronic components are supplied to the component pickup position of the component feeding unit 3B one by one, and picked up by the suction nozzles 5 of the mounting head 6 from the storage portions respectively.

The pair of front and rear beams 4A, 4B extending in the X direction are moved in the Y direction separately by sliders fixed to each of the beams 4A, 4B sliding along a pair of left and right guides extending in the front to rear direction, driven by each of Y direction linear motors 7. Each of the Y direction linear motors 7 includes a pair of upper and lower stationary members fixed to a pair of left and right bases 1A, 1B therealong, and moving members 7A fixed to the lower portions of attachment boards respectively provided on both the ends of each of the beams 4A, 4B.

The mounting heads 6 which move along guides in the longitudinal direction (the X direction) of the beams 4A, 4B by X direction linear motors 9 are provided on the beams 4A, 4B on the inside respectively, and each of the X direction linear motors 9 has a pair of front and rear stationary members fixed to each of the beams 4A, 4B and a moving member located between the stationary members which is provided on each of the mounting heads 6.

Therefore, the mounting heads 6 are provided on the beams 4A, 4B on the inside so as to face each other, and move above a printed board P on the board positioning portion 2B of the carrying device 2 or above the component pickup positions of the component feeding units 3B.

The twelve suction nozzles 5 are provided on each of the mounting heads 6 at predetermined intervals in a circle, being pushed downward by springs, and the suction nozzles 5 in the 3 o'clock and 9 o'clock positions of each of the mounting heads 6 may pick up electronic components simultaneously from the arrayed component feeding units 3B. The suction nozzles 5 are vertically movable by a vertical axis motor 10 and movable in the X and Y directions by rotating the mounting head 6 about a vertical axis by a θ axis motor 11, having a capability of rotating about the vertical axis and moving vertically.

A numeral 8 indicates a component recognition camera that takes images of electronic components held by the suction nozzles 5, and a numeral 12 indicates a board recognition camera 12 that takes images of recognition marks M1, M2 for positional recognition of a printed board P and mounted on each of the mounting heads 6. Numerals 13A, 13B indicate nozzle stockers storing various types of suction nozzles 5 and the maximum storable number of nozzles in each of the nozzle stockers is 24.

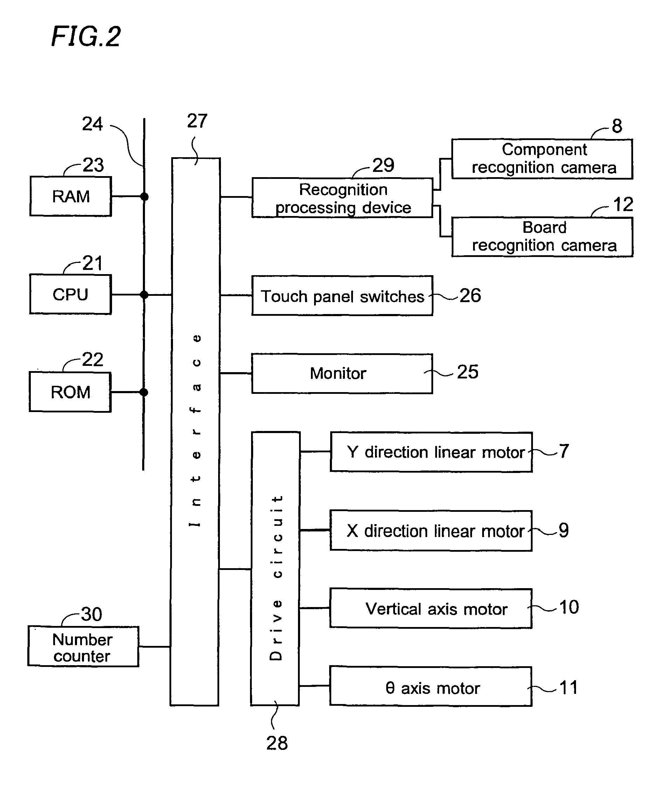

Fig. 2 is a control block diagram for the control of the electronic component mounting operation of the electronic component mounting apparatus 1, and this will be described hereafter. The components of the electronic component mounting apparatus 1 are controlled by a CPU (central processing unit) 21 as control means or check processing means, and connected to a ROM (read only memory) 22 storing programs for this control and a RAM (random access memory) 23 as memory means storing various data through a bus line 24. Furthermore, the CPU 21 is connected to a monitor 25 as a display device displaying an operation screen etc and touch panel switches 26 as input means formed on the display screen of the monitor 25 through an interface 27. Furthermore, the Y direction linear motor 9 etc are connected to the CPU 21 through a drive circuit 28 and the interface 27.

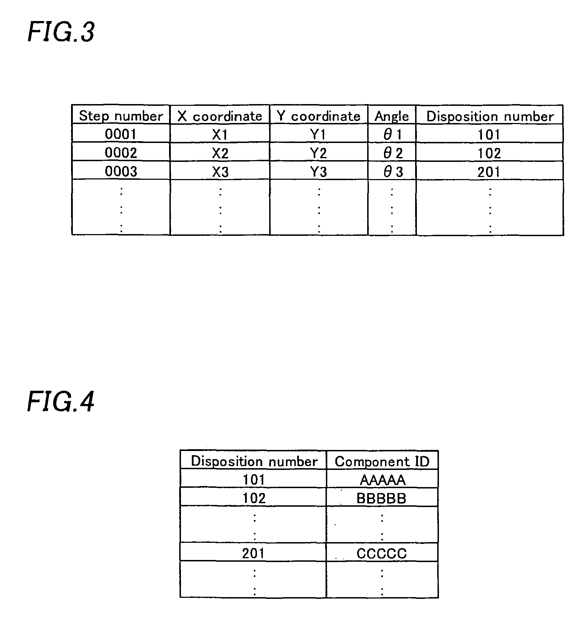

The RAM 23 is stored with mounting data for each of the types of printed boards P for component mounting, in which data about the X direction (indicated by X), the Y direction (indicated by Y) and an angle (indicated by Z) on each of the printed boards P and data about the disposition numbers of the component feeding units 3B, etc are stored in mounting order (in order of step number) (Fig. 3).

Furthermore, the RAM 23 is stored with data about the type (component ID) of each of electronic components corresponding to the disposition numbers (lane numbers) of the component feeding units 3B for each of the types of the printed boards P, i.e., component disposition data. This component disposition data is data about positions on the feeder base 3A where the component feeding units 3B are mounted respectively, as shown in Fig. 4.

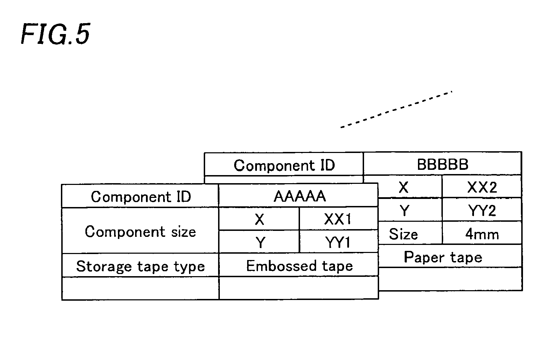

The RAM 23 is further stored with component library data about the features etc of the electronic components for each of the component IDs. In detail, this component library data includes sizes in the X and Y directions, the type of the storage tape C (an embossed tape, a paper tape), etc for each of the component IDs as shown in Fig. 5.

A numeral 29 indicates a recognition processing device connected to the CPU 21 through the interface 27. The recognition processing device 29 performs a recognition process to images taken and stored by the component recognition camera 12 or the board recognition camera 8, and sends the recognition result to the CPU 21. In detail, the CPU 21 outputs a command to perform a recognition process (e.g. the calculation of a shifting amount of an electronic component held by the suction nozzle 5 or a positioned printed board P from a proper position) to images taken and stored by the component recognition camera 12 or the board recognition camera 8 to the recognition processing device 29, and receives a recognition process result from the recognition processing device 29.

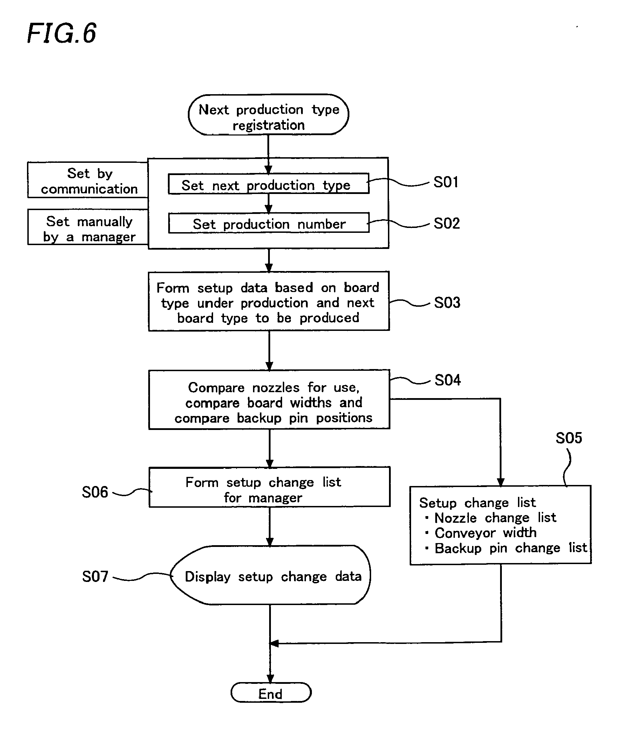

First, the type of printed boards P to be produced soon or printed boards P under production is already registered in each of the electronic component mounting apparatuses 1 forming the production line. Then the type of the next printed boards P to be produced is registered according to a flow chart of Fig. 6 and this will be described hereafter.

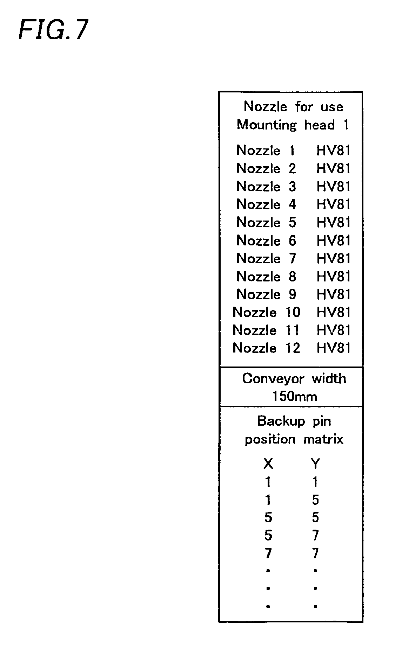

The type of the printed boards P to be produced soon or the printed boards P under production is already set, and this production type data is stored in the RAM 23 (Fig. 7). The electronic component mounting apparatus 1 mounts electronic components on a printed board P based on this production type data. This production type data includes suction nozzle data used for each of the mounting heads 6 for each of the board types (Fig. 7 shows one of the mounting heads and omits the other.), data about the conveyer width of the carrying device 2 and the disposition coordinates of backup pins supporting a printed board P from the lower side horizontally, and data about the number of this type of printed boards P to be produced. These suction nozzles 5, backup pins and carrying device 2 are work components for the operation of mounting electronic components on a printed board P.

In the production type data of the printed boards P to be produced soon or the printed boards P under production, the data about the type name of the printed board and the number of this type of printed boards P to be produced, and the work component data including the suction nozzle data, the conveyor width data of the carrying device 2 and the disposition coordinate data of the backup pins for each of the type names are separately stored in the RAM 23. However, these may be stored together instead of separately. When these data are separately stored as described above, the work component data are stored for each of the types of the printed boards P in advance, and then the type name of the printed boards and the number of this type of printed boards P to be produced are registered, thereby completing the setting of the work component data and the production number for this type of printed boards P.

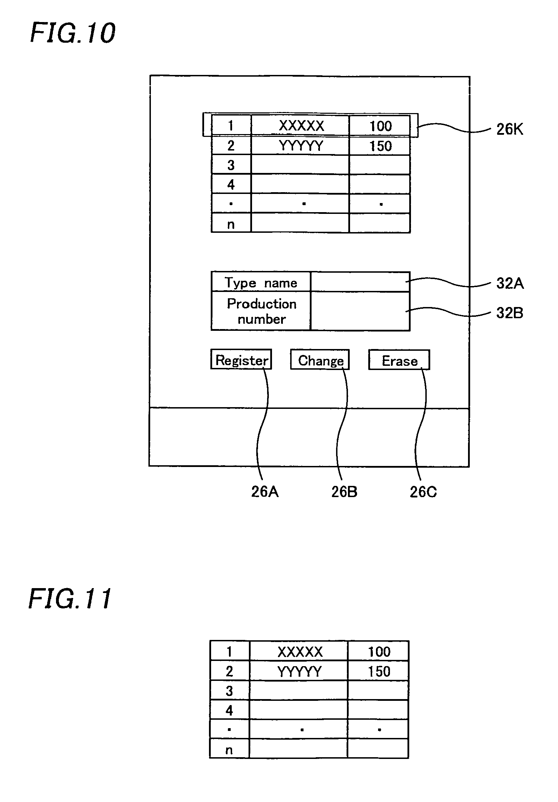

A description will be given about the registration of the type of the next printed boards P to be produced in the state where the type of the printed boards P to be produced soon or the printed boards P under production is thus registered. First, the type of the next printed board P to be produced is set. In detail, a production order list edit screen is displayed on the monitor 25 as shown in Fig. 10, and the type name of the printed boards to be produced is inputted to an input field 32A using alphabetical keys (not shown) and the number of this type of printed boards to be produced is inputted to an input field 32B using numeric keys (not shown). Then, by moving a cursor 26K to the first row (the topmost row indicated by "1") of an order list for the type of the first boards to be produced next and pressing a "register" switch 26A as one of the touch panel switches 26, the type and number of the first printed boards to be produced next is set (step S01 and step 02) and this content is stored in the RAM 23. Then the types and numbers of printed boards to be produced after this are also set in the same manner (in the "2" row displayed in the second row from the topmost row, and the rows therebelow), and the content as shown in Fig. 11 are stored in the RAM 23. In this case, the topmost row "1" means the first in the production order, "XXXXX" means the type name of the printed boards, and "100" means that the number of the printed boards to be produced is 100. Therefore, "2" in the second row from the top row means the second in the production order, the type name of the printed board is "YYYYY", and the number of the printed boards to be produced is 150.

Furthermore, corresponding to the type names of the printed boards, the work component data including the suction nozzle data, the conveyor width data of the carrying device 2, the disposition coordinate data of the backup pins, etc are stored in the RAM 23.

As described above, a manager inputs the types and numbers of the next printed boards to be produced manually using the monitor 25, the touch panel switches 26, etc. However, the manager may register these data by receiving these data from a managing computer, any one or a specified one of the board assembling apparatuses forming this board assembling line.

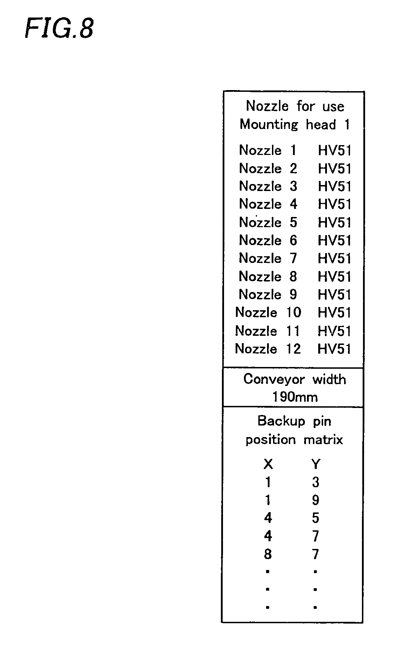

It is noted that the content of the next production type data registered in this manner (including the production number data and the work component data, see Fig. 8) is also set and stored in the other board assembling apparatuses forming the board assembling line in the same manner.

Then the CPU 21 forms setup data based on the production type data of the printed boards P under production and the next production type data of the next printed boards to be produced (including the production number data and the work component data, see Figs. 7 and 8) (step S03).

First, based on the setup data, the CPU 21 compares the suction nozzles, the conveyor widths of the carrying device 2 and the disposition coordinates of the backup pins that are used for the type of the printed boards under production and the type of the next printed boards to be produced (step S04).

Then the CPU 21 forms a setup change list based on the comparison mentioned above (step S05). In detail, in the case of the board type change from the type of the printed boards under production to the type of the next printed boards to be produced, the CPU 21 forms a change list for the suction nozzles, data about the amount of width of the conveyor to be increased or decreased, a change list of the backup pins, etc for the setup change that is automatically performed in the electronic component mounting apparatus 1, and ends.

Furthermore, for the setup change that can not automatically be performed in the electronic component mounting apparatus 1, the CPU 21 forms a setup change list for the manager (step S06). In detail, the CPU 21 forms a setup change list for work components to which the electronic component mounting apparatus 1 can not automatically make a setup change by itself for the manager. Then the CPU 21 displays setup change data which the manager is to execute on the monitor 25 (step S07). In this case, the CPU 21 may control the monitor 25 to display the setup change to be automatically performed and the setup change to be performed unautomatically in the component mounting apparatus 1 so as to distinguish one from another.

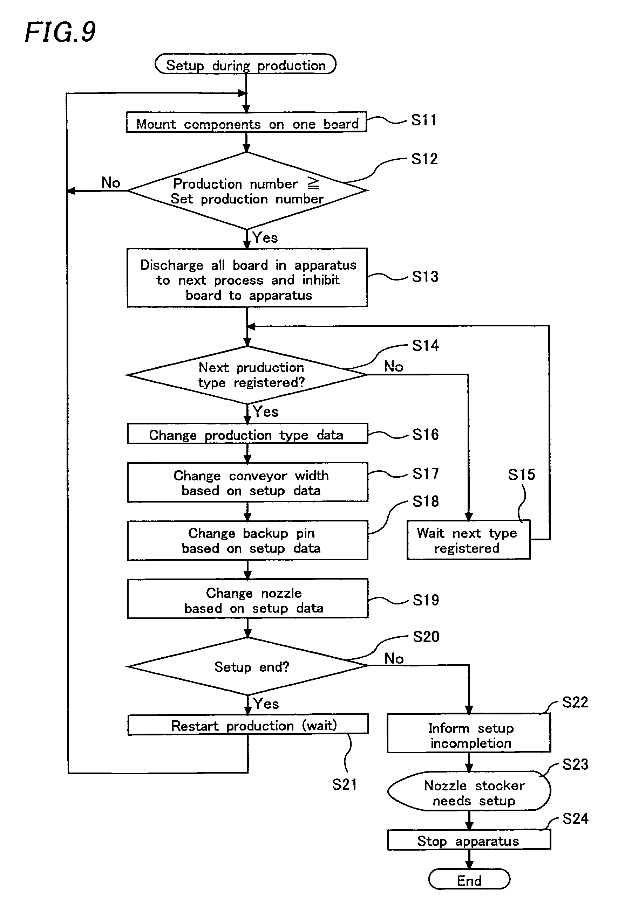

The next production type registration for the next boards to be produced is thus performed. Next, referring to a flow chart of Fig. 9, a setup operation during the production of the printed boards P will be described. First, an operation of mounting electronic components on a printed board P is performed by pressing an operation start switch (step S11) .

In detail, a printed board P is first brought from an upstream apparatus (not shown) to the board supply portion 2A of the carrying device 2, and the printed board P on this board supply portion 2A is moved to the board positioning portion 2B and fixedly positioned. After the printed board P is positioned, one beam 4A mounted on the electronic component mounting apparatus 1 is moved in the Y direction by the Y direction linear motor 7, and simultaneously the mounting head 6 mounted on the beam 4A is moved in the X direction by the X direction linear motor 9, reaching a position above the component pickup position of the corresponding component feeding unit 3B. Then the suction nozzle 5 mounted on the mounting head 6 is descended by the vertical axis motor 10 to pick up an electronic component from the component feeding unit 3B.

After picking up electronic components, the suction nozzles 5 of the mounting head 6 are ascended, and the mounting head 6 of the beam 4A passes above the component recognition camera 8. During this movement, the camera takes images of the plurality of electronic components held by the plurality of suction nozzles 5 sequentially, and the recognition processing device 29 performs a recognition process to these images and recognizes the positional shifts of the electronic components relative to the suction nozzles.

The board recognition camera 12 mounted on each of the mounting heads 6 is moved to above the printed board P and takes images of positioning marks M1, M2 given to the printed board P. The recognition processing device 29 performs a recognition process to the images to recognize the position of the printed board.

Then the result of the recognition process of the positioning marks of the printed board P and the result of the component recognition process are added to the mounting coordinates in the mounting data, and the suction nozzles 5 correct the positional shifts and mount the electronic components on the printed board P. After all the electronic components are thus mounted on the printed board P, this printed board is moved from the board positioning portion 2B to the downstream apparatus through the board discharge portion 2C, thereby completing the operation of mounting the electronic components on this printed board P.

All the electronic components are thus mounted on the printed board P as described above. Each time when the operation of mounting all electronic components on a printed board is completed, a production board number counter 30 increases the count number by "1", and the CPU 21 judges whether or not the number of produced boards reaches the set production number mentioned above (step S12).

Then the component mounting operation is continued and printed circuit boards P are produced sequentially. When the count number of the production board number counter 30 reaches the set production number and the CPU 21 judges that the count number reaches the set production number and the production is completed, all the printed boards P in this electronic component mounting apparatus 1 are discharged to the next process (to the downstream board assembling apparatus) and a printed board P is inhibited from being brought to this electronic component mounting apparatus 1. In detail, the CPU 21 controls the board assembling apparatuses such as the upstream electronic component mounting apparatuses 1 so as not to request a printed board P (step S13).

Alternatively, the production time per board that is the time necessary to mount electronic components on one printed board P may be measured in advance and the time necessary to produce the number of boards to be produced may be stored in the RAM 23, and a timer (not shown) may be provided. Then the CPU 21 judges whether or not the timer reaches a production end time that is the time when the production of the set number of boards to be produced is to be completed from a production start time. When the CPU 21 judges that the timer reaches the production end time, all the printed boards P in this electronic component mounting apparatus 1 are discharged to the next process (to the downstream board assembling apparatus) and a printed board P is inhibited from being brought to this electronic component mounting apparatus 1 as described above.

Alternatively, a mark may be given to the last printed board P to be produced. Then when a detection device detects this mark and the operation of mounting electronic components on this last printed board P is completed, the CPU 21 judges that the number of this type of produced printed boards P reaches the set production number, and then discharges all the printed boards P in this electronic component mounting apparatus 1 to the next process (to the downstream board assembling apparatus) and inhibits a printed board P from being brought to this electronic component mounting apparatus 1 as described above.

The CPU 21 then judges based on the stored content in the RAM 23 whether or not the next production type registration is completed (step S14). When the CPU 21 judges that the next production type registration is not completed, the CPU 21 wait until the next production type registration is completed (step S15).

When the CPU 21 judges that the next production type registration is completed, the CPU 21 changes the production type data (step S16). In detail, the CPU 21 sends the next production type data to a storage area for production type data in the RAM 23, rewrites and stores the next production type data, and erases the stored previous production type data.

Then, based on the formed setup change list (step S05 in Fig. 6), corresponding to the next type of printed boards P to be produced, the conveyor width of the pair of conveyors of the carrying device 2 is changed at the board supply portion 2A, the board positioning portion 2B and the board discharging portion 2C (step S17). In detail, the CPU 21 controls a drive source for movement so as to move one or both of the pair of conveyors by the amount of width to be increased or decreased that is a difference between the conveyor width for the type of the printed boards completing the production and the conveyor width for the next type of printed boards to be produced.

Then, based on the setup change list, corresponding to the next type of printed boards P to be produced, according to the change list of the backup pins, the backup pins on a backup table 14 are changed (step S18). In detail, the CPU 21 performs a necessary control so as to change the backup pins for necessary backup pins corresponding to a difference between the disposition state of the backup pins for the type of the printed boards completing the production and the disposition state of the backup pins for the next type of printed boards to be produced.

Then, based on the setup change list, corresponding to the next type of printed boards P to be produced, according to the change list of the suction nozzles 5, the suction nozzles 5 mounted on each of the mounting heads 6 are changed (step S19). In detail, the CPU 21 performs a necessary control for the demounting or mounting of the suction nozzles 5 so as to pick up necessary suction nozzles 5 from the nozzle stockers 13A, 13B and mount these on the mounting head 6 corresponding to a difference between the disposition state of the suction nozzles 5 for the type of printed boards completing the production and the disposition state of the suction nozzles 5 for the next type of printed boards to be produced.

As described above, this setup change operation of the work components corresponding to the next type of printed boards P to be produced is performed after the completion of the ongoing production in this board assembling apparatus 1, utilizing the time until the completion of the ongoing production in the last board assembling apparatus or the time during the ongoing production in the downstream board assembling apparatuses.

Then, after the setup change operation is performed, the CPU 21 judges whether or not the setup changes are completed (step S20). In detail, when the CPU 21 judges that all the necessary setup changes are completed, the CPU 21 controls the apparatus so as to start producing the next type of printed boards P (step S21). In detail, the apparatus starts the production when the production is startable immediately (when there is a printed board P in the upstream board assembling apparatus or on the board supply portion 2A that is on the more upstream side than the board positioning portion 2B), or waits when the production is not startable immediately (when there is not a printed board P in the upstream board assembling apparatus).

However, when the CPU 21 judges that all the necessary setup changes are not completed even after the setup change operation, the CPU 21 informs the setup change incompletion (step S22). In detail, the CPU 21 displays the setup change incompletion on the monitor 25 as informing means or informs the setup change incompletion using other visual or audio informing means.

For example, for the change of the suction nozzles, the monitor 25 as informing means displays "Nozzle stockers need setup." (step S23). After the displaying, the CPU 21 controls the electronic component mounting apparatus 1 to stop the mounting operation (step S24). In detail, the CPU 21 controls the upstream apparatus so as to stop and not to send a request signal for a printed board and controls the board supply portion 2A so as to stop and not to carry a printed board P to the positioning portion 2B. After the stopping, the manager makes the necessary change of the suction nozzles 5 based on the setup change list for the manager formed in the step S06 of Fig. 6.

Furthermore, for the change of the backup pins as well as the change of the suction nozzles, the monitor 25 displays "Backup pins need setup.", and the manager makes the necessary change of the backup pins based on the setup change list for the manager formed in the step S06 of Fig. 6.

As described above, the production efficiency of printed circuit boards is increased by enabling an apparatus that already completes production in a board assembling line to perform setup change operations to work components during the time until the last apparatus completes production or the time when the downstream board assembling apparatus is producing a board.

The embodiments of the invention are described above. It is recognized that variations or modifications of the disclosed method are possible based on the disclosure for those skilled in the art and lie within the scope of the invention.

## Claims

1. A method of controlling a board assembling apparatus (1) forming a board assembling line and comprising a plurality of work components (2, 5) necessary for a work of mounting electronic components on a board (P), the method comprising:
performing a work of mounting electronic components on a first board (P) based on a first production type data stored in a memory (23);
judging whether or not a second production type data necessary for a work of mounting electronic components on a second board (P) is stored in the memory (23) when the work of mounting the electronic components on the first board (P) is completed; and
performing a necessary setup change operation of the work components (2, 5) based on the first and second production type data so as to perform the work of mounting the electronic components on the second board (P) when it is judged that the second production type data is stored in the memory (23).

2. The method of claim 1, further comprising judging whether or not the work of mounting the electronic components on the first board (P) is completed, and judging whether or not the second production type data is stored in the memory (23) when it is judged that the work of mounting the electronic components on the first board (P) is completed.

3. The method of claim 1 or 2, further comprising informing that the necessary setup change is not made to the work components (2, 5) when the necessary setup change is unable to be made to the work components (2, 5).

4. The method of claim 1 or 2, further comprising stopping the board (P) assembling apparatus (1) when the necessary setup change is unable to be made to the work components (2, 5).

5. The method of any one of claims 1 to 4, wherein the plurality of work components (2, 5) comprises a suction nozzle (5) for the electronic component, a carrying device (2) for the board (P), and a backup pin supporting the board (P), wherein each of the first and second production type data comprises a setup change data of the suction nozzle (5), conveyor width of the carrying device (2), and disposition coordinate data of the backup pin.

6. A board assembling apparatus forming a board assembling line and comprising a plurality of work components (2, 5) necessary for a work of mounting electronic components on a board (P), the board assembling apparatus comprising:
a memory (23);
a first judging means (21) judging whether or not a second production type data necessary for a work of mounting electronic components on a second board (P) is stored in the memory (23) when a work of mounting electronic components on a first board (P) based on a first production type data stored in the memory (23) is completed; and
a control means (21) performing a necessary setup change operation of the work components (2, 5) based on the first and second production type data so as to perform the work of mounting the electronic components on the second board (P) when it is judged that the second production type data is stored in the memory (23).

7. The board assembling apparatus of claim 6, further comprising a second judging means (21) judging whether or not the work of mounting the electronic components on the first board (P) is completed, wherein the first judging means (21) judges whether or not the second production type data is stored in the memory (23) when the second judging means (21) judges that the work of mounting the electronic components on the first board (P) is completed.

8. The board assembling apparatus of claim 6 or 7, further comprising an informing means (25) informing that the necessary setup change is unable to be made to the work components (2, 5) when the necessary setup change is unable to made to the work components (2, 5).

9. The board assembling apparatus of claim 6 or 7, further comprising a stop control means (21) stopping the board assembling apparatus (1) when the necessary setup change is unable to be made to the work components (2, 5).

10. The board assembling apparatus of any one of claims 6 to 8, wherein the plurality of work components (2, 5) comprise a suction nozzle (5) for the electronic component, a carrying device (2) for the board (P), and a backup pin supporting the board (P), wherein each of the first and second data comprises a change data of the suction nozzle (5), conveyor width of the carrying device (2), and disposition coordinate data of the backup pin.
